# DEMANDE DE BREVET EUROPEEN

(11) **EP 4 704 542 A1**
(43) Date de publication de la demande: **04.03.2026**
(21) Numéro de dépôt: 25196927.5
(22) Date de dépôt: 20.08.2025
(51) Int. Cl.: H10W 42/20, H10W 70/60, H10W 70/685, H10W 74/10, H10W 90/00, B22F 7/08, B22F 10/28, B33Y 10/00, B33Y 80/00, B22F 10/18

(54) **STRUCTURE DE PROTECTION 3D CONTRE LES INTERFÉRENCES ÉLECTROMAGNÉTIQUES POUR DISPOSITIF SEMI-CONDUCTEUR**

(30) Priorité: 28.08.2024 FR 2409165
(71) Demandeur: STMicroelectronics International N.V., 1228 Plan-les-Ouates, Geneva (CH)
(72) Inventeur: COGONI, Deborah, 38470 Notre Dame de l'Osier (FR); VELAYUDHAN, Vipin, 38100 Grenoble (FR)
(74) Mandataire: Casalonga

(57) **Abrégé**

Dispositif semi-conducteur comprenant un boitier de circuit intégré (1) présentant une matrice de connexion (6) pour une connexion à un circuit imprimé (15) caractérisé en ce que le boitier de circuit intégré (1) comprend une structure de protection (2) contre des interférences électromagnétiques des connecteurs élémentaires (3, 4), tels que de billes, formée par un dépôt par impression 3D d'une paroi métallique (11) de protection entre les connecteurs élémentaires (3, 4).

## Description

### Domaine technique

La présente invention concerne la protection d'un circuit imprimé (PCB) contre des interférences électromagnétiques (EMI) générées par divers composants élémentaires du circuit imprimé, plus particulièrement les interférences électromagnétiques au sein d'une matrice de connexion, type billes de soudure (BGA), pastilles de connexion (LGA) ou broches de connexion (PGA).

### Techniques antérieures

Un courant électrique circulant dans des composants d'un circuit imprimé génère un champ électromagnétique. Un signal électromagnétique se propage alors avec une composante de champ électrique et une composante de champ magnétique ce qui peut entraîner des interférences électromagnétiques entre les composants eux-mêmes. L'interférence électromagnétique est la génération de signaux électriques indésirables dans les circuits des systèmes électroniques en raison du couplage involontaire de l'énergie d'un champ électromagnétique incident.

Dans les systèmes électroniques très compacts, la dimension de l'élément ou composant moyen du circuit diminue, ce qui favorise le rayonnement de signaux de fréquence plus élevée. La fréquence de fonctionnement croissante de ces systèmes électriques entraîne un niveau élevé d'interférences électromagnétiques (EMI) à haute fréquence. La prédominance des systèmes haute fréquence et des circuits électroniques portables créent un environnement très complexe pour le fonctionnement des systèmes électriques/électroniques sensibles. En conséquence, il est souvent avantageux de protéger un composant électrique/électronique contre des EMI émises par d'autres composants.

Les composants électriques sensibles ou rayonnants peuvent être recouverts d'un couvercle et/ou d'un boîtier métallique, connecté à un plan de masse lors du processus de fixation du couvercle en place. Les protections existantes offrent des capacités de réutilisation limitées et sont dédiées à des composants individuels. Ces protections sont souvent des plaques, plaques perforées, cages ou maillages métalliques qui couvrent un circuit entier ou certains composants spécifiques.

Les protections métalliques sont souvent coûteuses, lourdes et difficiles à miniaturiser pour protéger notamment les composants contre des EMI internes.

### Exposé de l'invention

Il existe donc un besoin de proposer des protections aux EMI internes pour certains composants.

Il a été observé que les courants électriques circulant dans des matrices de connecteurs élémentaires sont sources d'EMI entre les connecteurs élémentaires.

Une matrice de connexion est un ensemble de connecteurs de très petite taille (inférieur au millimètre) qui permettent de connecter électriquement un boîtier de circuit intégré à un circuit imprimé.

La matrice de connexion peut être de type matrice de billes ou BGA (pour « Ball Grid Array ») où les connecteurs élémentaires sont des billes de soudure, de type matrice de pastilles ou LGA (pour « Land Grid Array ») où les connecteurs élémentaires sont des pastilles (pads) de connexion, ou de type matrice de broches ou PGA (pour « Pin Grid Array ») où les connecteurs élémentaires sont des broches de connexion, ou encore de type matrice de colonnes ou CGA (pour « Column Grid Array ») où les connecteurs élémentaires sont des colonnes de soudure.

Il est donc souhaitable de réduire les EMI entre connecteurs élémentaires.

Il est important de limiter les EMI entre ces connecteurs élémentaires avec un dispositif de protection pouvant s'adapter à des formes complexes de connecteurs élémentaires disposés sur la matrice de connexion.

Un dispositif semi-conducteur comprend un boitier de circuit intégré présentant une matrice de connexion pour une connexion à un circuit imprimé. Le boitier de circuit intégré comprend une structure de protection contre des interférences électromagnétiques des connecteurs élémentaires d'éléments de connexion formée par un dépôt métallique formant paroi de protection entre les connecteurs élémentaires.

Ainsi, les EMI émises par les connecteurs élémentaires sont réduites par la paroi métallique entre ceux-ci.

Lorsque les EMI entrent en contact avec la paroi de protection, la paroi métallique réfléchit la plupart des ondes électromagnétiques, tandis qu'une partie des EMI est absorbée et convertie en chaleur. L'énergie restante est confinée au sein de la paroi métallique en raison de l'effet de peau, empêchant ainsi les EMI d'atteindre des composants électroniques sensibles de l'autre côté de la paroi métallique.

Les parois métalliques permettent de réfléchir et absorber les EMI ainsi que générer l'effet de peau pour les EMI ce qui rend les parois métalliques particulièrement efficaces pour bloquer les EMI, protégeant ainsi les composants électroniques des EMI.

Dans un mode de réalisation, la paroi métallique est électriquement connectée avec une piste de masse du circuit intégré.

La paroi métallique permet d'absorber les signaux électriques induis par les interférences électromagnétiques émises par les connecteurs élémentaires et de conduire ces signaux électriques vers le plan de masse du boitier de circuit.

En particulier, au moins une partie de la paroi métallique est déposée directement sur la piste de masse. Aussi, la piste de masse peut avoir été découverte entre des connecteurs élémentaires, avant dépôt de la paroi métallique. Cette disposition permet de réaliser en une même opération (dépôt métallique) la protection EMI et sa connexion électrique au plan de masse.

Avantageusement, la structure de protection comprend une couche d'isolation couvrant la paroi métallique.

La couche d'isolation permet ainsi d'éviter un court-circuit entre les connecteurs élémentaires lors de connexion de la matrice de connexion au circuit imprimé. En effet, lors de connexion de la matrice au circuit imprimé, ces connecteurs élémentaires peuvent être soudés au circuit imprimé ou être compressés, créant un risque de contact avec la paroi de protection. La couche d'isolation permet donc d'éviter un contact électrique, et donc des chemins électriques non maitrisés.

Préférentiellement, la matrice de connexion est au moins l'une entre une matrice de broches (PGA), une matrice de billes (BGA), une matrice de pastilles (LGA) ou une matrice de colonnes (CGA).

Avantageusement, la structure de protection présente une hauteur substantiellement égale à une hauteur des connecteurs élémentaires après connexion de la matrice au circuit imprimé. La hauteur est définie selon la normale au plan de la matrice de connexion.

Lors de la soudure ou de la compression des connecteurs élémentaires, la hauteur des connecteurs élémentaires est souvent amenée à se réduire par l'effet de la chaleur ou des forces soumises. La hauteur de la structure de protection est choisie substantiellement égale à la hauteur des connecteurs élémentaires après connexion de la matrice au circuit imprimé pour former une barrière EMI sur l'intégralité de la hauteur entre le dispositif semi-conducteur et le circuit imprimé.

Dans un mode de réalisation, la matrice de connexion est disposée sur une face inférieure d'un circuit imprimé support du boitier de circuit intégré, la structure de protection comprenant au moins une première portion de protection formée par dépôt métallique sur une tranche latérale du circuit imprimé support.

Un circuit imprimé support est généralement constitué par une pluralité de couches internes, alternant couche de diélectrique et couche conductrice. Le courant électrique circulant dans ces dernières génère des EMI non négligeables. En formant au moins une portion de protection sur une tranche latérale du circuit imprimé, de préférence à hauteur des zones très émettrices, l'émission des EMI provenant de circuit imprimé support est largement réduite.

Avantageusement, l'au moins une première portion de protection présente la forme d'un peigne s'étendant sur une portion de la tranche latérale du circuit imprimé. Un peigne est, par exemple, formé d'une multitude de doigts ou brins substantiellement parallèles s'étendant ainsi sur la tranche latérale.

La première portion en forme de peigne permet avantageusement une formation rapide, par exemple, par impression 3D, tout en réduisant la matière requise pour former une structure de protection contre les EMI.

La première portion de protection peut s'étendre sur toute l'épaisseur du circuit imprimé support ou sur une partie seulement du circuit imprimé support dans le cas où les couches conductrices à forte émission des EMI sont des couches basses dans le circuit imprimé support, par exemple.

Dans un exemple de réalisation, l'au moins une première portion de protection s'étend au-delà de l'épaisseur du circuit imprimé, jusqu'à une hauteur de composants électriques disposés sur le circuit imprimé support. Cette réalisation permet de réduire également les EMI de ces composants électriques.

Dans un mode de réalisation, la structure de protection comprend une deuxième portion de protection, réalisée par dépôt métallique, formant cadre périphérique de la face inférieure du circuit imprimé support.

Le courant circulant sur le bord du circuit imprimé support est ainsi limité. La portion de protection en forme de peigne peut notamment s'étendre sur la tranche latérale du circuit imprimé depuis la portion formant cadre périphérique du PCB porteur.

Dans un aspect de l'invention, la paroi métallique, la couche d'isolation, la première et la deuxième portions le cas échéant, sont déposées sur le substrat porteur par une impression 3D.

L'impression 3D de la structure de protection est particulièrement avantageuse car elle permet de déposer la paroi métallique, la couche d'isolation et la portion de protection d'une manière plus efficace et plus ergonomique. L'impression 3D permet également de miniaturiser la structure de protection formée entre les connecteurs élémentaires et d'adapter la forme de la structure de protection aux géométries complexes de la matrice de connexion.

Préférentiellement, la structure de protection forme une grille de parois métalliques rectilignes, perpendiculaires entre elles, et disposées entre les connecteurs élémentaires organisés en quadrillage au sein de la matrice.

La grille avec des lignes perpendiculaires correspond souvent à la position des connecteurs élémentaires. Cette disposition permet de mieux isoler les émissions EMI à l'échelle du connecteur élémentaire.

Un procédé de fabrication d'un dispositif semi-conducteur comprend les étapes suivantes :
- obtenir un boitier de circuit intégré présentant une matrice de connexion pour une connexion à un circuit imprimé ; et
- former une structure de protection contre des interférences électromagnétiques entre les connecteurs élémentaires par dépôt métallique formant paroi de protection entre les connecteurs élémentaires.

Dans un mode de réalisation, la formation de la structure de protection comprend en outre une ou plusieurs opérations parmi :
une étape de dépôt d'une couche d'isolation (9) sur la paroi de protection (11),
une étape de dépôt métallique sur une tranche latérale d'un circuit imprimé support métallique sur la face intérieure duquel est disposée la matrice de connexion, de sorte à former une portion de protection latérale, présentant optionnellement la forme d'un peigne,
une étape de dépôt métallique formant cadre périphérique de la face inférieure du circuit imprimé support.

Selon un aspect de l'invention, le ou les dépôts métalliques et le dépôt de la couche d'isolation le cas échéant sont réalisés par impression 3D.

### Brève description des dessins

La Figure 1 [Fig 1] illustre un dispositif semi-conducteur comprenant un boitier de circuit connecté à un PCB de connexion.
La Figure 2A [Fig 2A], la figure 2B [Fig 2B] et la figure 2C [Fig 2C] illustrent un dispositif semi-conducteur comprenant un boitier de circuit avec une structure de protection.
La Figure 3A [Fig 3A], la figure 3B [Fig 3B] et la figure 3C [Fig 3C] illustrent un exemple de dépôt d'une structure de protection entre des connecteurs élémentaires.
La Figure 4 [Fig 4] illustre un exemple d'une portion de protection déposée sur un côté latéral d'un circuit imprimé.
La Figure 5 [Fig 5] présente un logigramme d'un procédé de de fabrication d'un dispositif semi-conducteur comprenant une structure de protection contre des interférences électromagnétiques entre les connecteurs élémentaires.

Par souci de clarté, de mêmes éléments sont désignés par de mêmes références dans les différentes figures. Par ailleurs, les diverses figures ne sont pas tracées à l'échelle, comme cela est habituel dans la représentation des circuits intégrés.

### Description détaillée

Dans la description, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un circuit électronique dans une position normale d'utilisation. Sauf précision contraire, les expressions "environ", "approximativement", "sensiblement", et "de l'ordre de" signifient à 10 % près, de préférence à 5 % près. Dans la suite de la description, le terme "conducteur" signifie conducteur électriquement et le terme "isolant" signifie isolant électriquement.

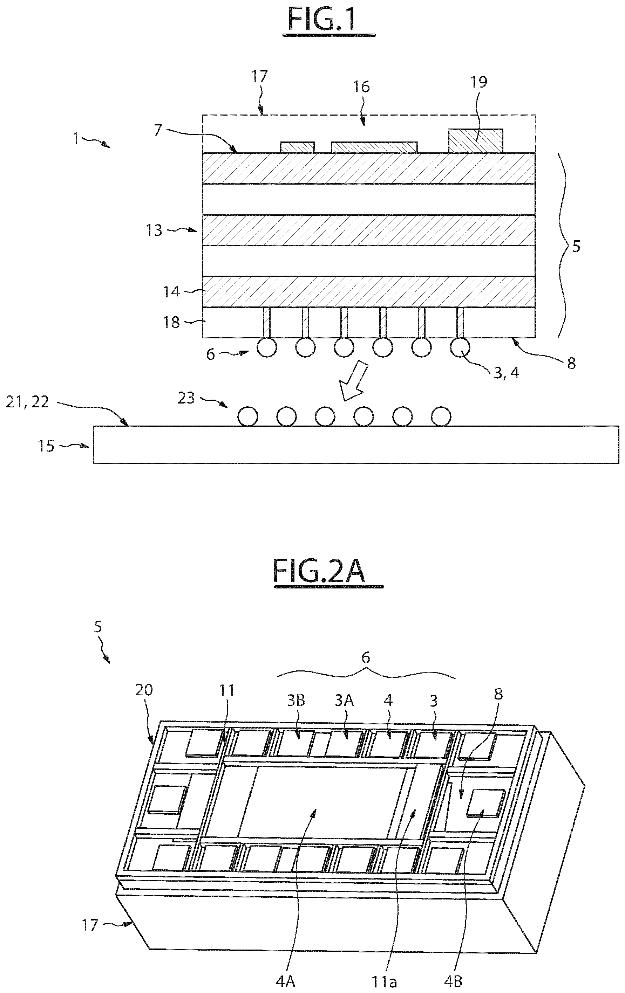

La figure 1 illustre un dispositif semi-conducteur comprenant un boitier de circuit intégré 1. L'ensemble est conçu pour être connecté à une carte de circuit imprimé ou PCB de connexion 15 au travers d'une matrice de connexion 6 formée de connecteurs élémentaires 3, 4 telle que décrite par la suite.

De façon connue, le boitier de circuit intégré 1 comprend un circuit intégré 16 recouvert d'un capot 17 typiquement en résine.

Le circuit intégré 16 est formé d'une carte de circuit imprimé PCB « porteur » ou « support » 5 sur la surface (supérieure) de montage 7 duquel sont montés un ou plusieurs composants électroniques 19 formant assemblage de circuit intégré 16. A titre d'exemple, un composant électronique peut comprendre une puce semi-conductrice, qui est un dispositif de circuit intégré à semiconducteurs tel qu'un microprocesseur, une mémoire, un dispositif logique, un dispositif analogique ou une autre fonction électronique implémentée dans un circuit intégré à puce unique, comme connu dans l'art antérieur.

Le PCB porteur 5 est généralement composé d'un substrat 18 et d'une pluralité de couches successives (piste conductrice puis diélectrique). Les couches conductrices étant réliées entre elles par des connexions internes (non représentées), par exemple des vias ou trous métallisés.

Les composants électriques sont connectés électriquement aux pistes du PCB porteur 5. Le substrat du PCB porteur 5 peut être un substrat en céramique, en résine époxy, en tissu de verre ou de papier. Le PCB porteur 5 comprend, opposée à la face de montage 7, une face de connexion 8 comprenant une matrice de connexion 6. La matrice de connexion 6 est configurée pour connecter électriquement le boitier de circuit intégré 1 au PCB de connexion 15 (lequel comprend une matrice de connexion complémentaire 21).

Dans le processus de conception, le capot 17 est déposé sur la face de montage 7 du PCB porteur 5 de sorte à recouvrir les composants électroniques 19 montés en surface. Dans cette configuration, les tranches 13 (ou faces latérales) du PCB porteur 5 ne sont pas recouvertes par la résine du capot 17.

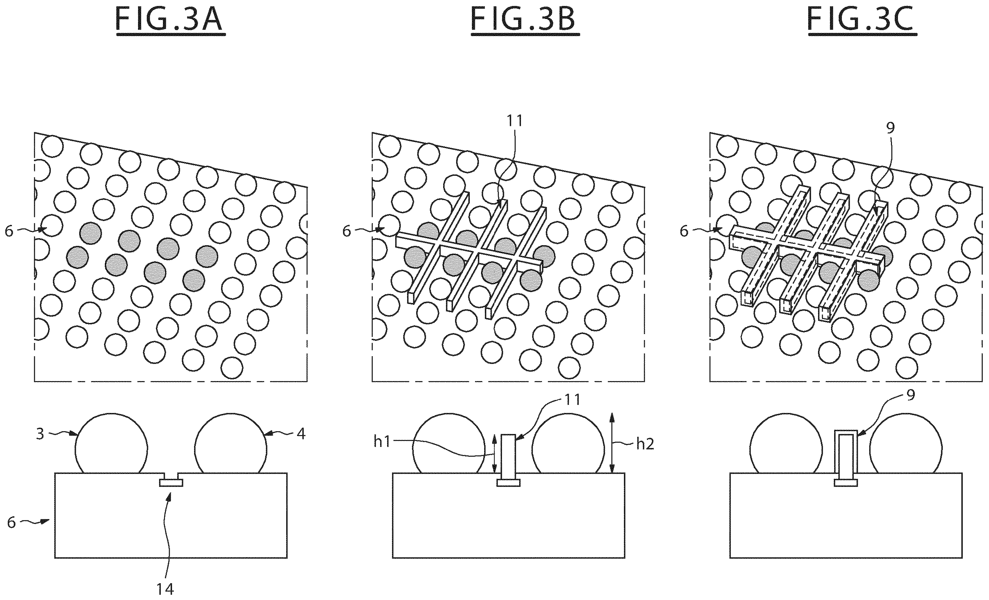

La matrice de connexion 6 comprend une pluralité des connecteurs élémentaires 3, 4. Dans un exemple non-limitatif, la matrice de connexion 6 est une matrice de broches (PGA), une matrice de billes (BGA), une matrice de pastilles (LGA) ou une matrice de colonnes (CGA). Les connecteurs élémentaires 3, 4 peuvent être organisés en un quadrillage régulier (selon des rangées et des colonnes régulières - voir par exemple Fig. 3A-3B) ou de façon moins régulière (Figure 2A-2B).

De façon connue, le PCB de connexion 15 comprend une alternance de couches conductrices et de couches isolantes ou diélectriques, les couches conductrices étant réliées entre elles par des connexions internes, par exemple des vias ou trous métallisés. Une face 22 dite de connexion comporte des connecteurs élémentaires complémentaires 23 (voir Fig. 1) à ceux du boitier de circuit intégré 1 : par exemple, des pastilles, des trous traversants ou encore des sockets.

Ainsi, le boitier de circuit intégré 1 peut être électriquement connecté au PCB de connexion 15 via des billes, des pastilles, des colonnes, des broches ou d'autres connecteurs élémentaires connus, en alignant ces connecteurs élémentaires de leurs faces de connexion respectives.

La connexion entre le boitier de circuit intégré 1 et le PCB de connexion 15 peut être assurée par soudure, collage, insertion, la compression ou tout autre moyen de connexion connu. Dans un exemple préférentiel, les connecteurs élémentaires 3, 4, tels que les pastilles ou les billes sont soudés pour assurer la connexion électrique.

Le PCB porteur 5 comporte une couche isolante 18 formant surface externe de la face de connexion 8, et sous la couche isolante 18 (au-dessus sur la figure), une piste de masse 14 connectée, de façon connue, à un plan de masse pour évacuer tout courant indésirable (e.g., courant de fuite). Dans un exemple préférentiel, la piste de masse 14 forme la couche immédiatement après la couche isolante 18 formant surface externe du PCB porteur 5.

Dans un mode de réalisation, la piste de masse 14 est située entre les connecteurs élémentaires 3, 4, par exemple entre chaque rangée des connecteurs élémentaires 3, 4, comme illustré à la Fig. 3A-3B. Dans un autre mode de réalisation, une borne de la piste de masse 14 peut être disposée hors de la matrice de connexion 6 pour être reliée par un fil électrique (technologie dite de « wire bonding ») à la structure de protection EMI selon la présente divulgation.

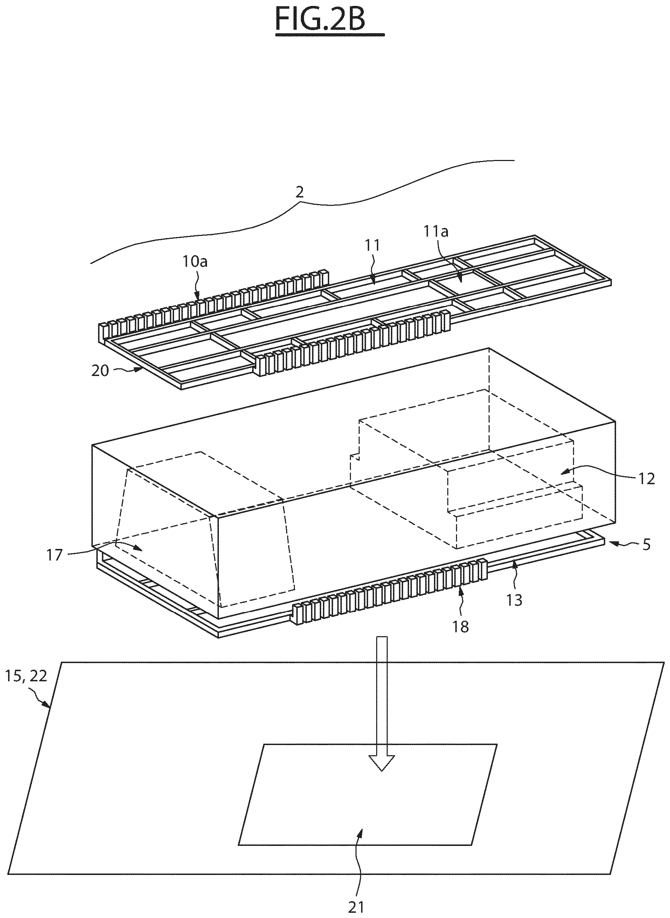

La Figure 2A illustre un dispositif semi-conducteur comprenant un boitier de circuit avec une structure de protection EMI 2. La Figure 2B illustre la connexion entre le PCB porteur 5 et le PCB de connexion 15. Afin de limiter des interférences électromagnétiques émises par les connecteurs élémentaires 3, 4, la structure de protection 2 est formée par un dépôt métallique formant paroi ou muret 11 de protection, disposée verticalement (par rapport à la matrice de connexion 6 et donc au plan de la couche isolante 18 ou une face de connexion 8), entre les connecteurs élémentaires 3, 4.

La paroi de protection 11 peut être déposée, par exemple, sans vouloir être limitatives, par le dépôt chimique en phase vapeur (CVD), le dépôt chimique en phase vapeur assisté par plasma (PECVD), la pulvérisation cathodique, l'évaporation, la sérigraphie, pulvérisation, le placage, ou l'impression 3D. Dans un exemple, l'impression 3D est préférée. L'impression 3D peut être au moins l'un parmi un frittage sélectif par laser (SLS), une stéréolithographie (SLA), un dépôt de fil fondu (FDM), une fusion multi-jets ou Multi Jet Fusion (MJF), une fusion sélective par laser (DMLS), un Polyjet ou une Carbon DLS (pour Digital Light Synthesis).

Fig. 3A-3C illustre un mode de réalisation de fabrication de la structure de protection EMI 2. Il s'agit ici de réaliser la structure de protection EMI pour une matrice de billes réparties de façon régulière sous forme de quadrillage.

Dans une première étape illustrée à la Fig. 3A, la couche isolante 18 de PCB porteur est gravée. La couche isolante 18 peut être gravée sensiblement au milieu entre deux connecteurs élémentaires 3, 4 comme illustré de sorte à découvrir la piste masse 14. La gravure peut être ponctuelle pour former une borne de connexion localisée, ou être étendue sous forme de rainure, notamment avec une ou plusieurs sections longitudinales entre les connecteurs élémentaires 3, 4, de la forme d'une ou plusieurs parois de protection 11 à créer.

La couche isolante 18 peut être également gravée à une extrémité du PCB porteur 5 hors de la matrice de connexion 6.

Dans une deuxième étape illustrée à la Fig. 3B, un dépôt métallique de la paroi de protection 11 entre les connecteurs élémentaires 3, 4 est réalisé, typiquement par impression 3D. Le dépôt métallique présent typiquement un dépôt longitudinal formant des murets. Dans l'exemple de la Figure 3B, la structure de protection 2 forme une grille de parois métalliques 11 rectilignes, perpendiculaires entre elles, et disposées entre les connecteurs élémentaires 3, 4 organisés en quadrillage au sein de la matrice de connexion 6.

Comme il est présenté sur la Figure 3B, la structure de protection 2 présente une hauteur h1 (selon l'axe perpendiculaire au plan de la matrice de connexion 6) substantiellement égale à une hauteur h3 (non illustrée) des connecteurs élémentaires 3, 4 après connexion de la matrice de connexion 6 au PCB de connexion 15. La hauteur h2 des connecteurs élémentaires 3, 4 illustrée à la Fig. 3B, correspond à la hauteur des connecteurs avant la connexion de la matrice 6 au PCB de connexion 15. En effet, la hauteur des billes h2 de connexion 3, 4 a vocation à se réduire sous l'effet par exemple d'opérations de soudure.

Ainsi, la structure de protection 2 ne dépasse pas (aux incertitudes de conception près) la hauteur h3 des connecteurs élémentaires 3, 4 après fixation au PCB de connexion 15 et ne gêne donc pas la connexion de la matrice de connexion 6 au PCB de connexion 15.

Dans un exemple non limitatif, dans lequel les billes de connexion sont utilisées en tant que les connecteurs élémentaires 3, 4 la hauteur h2 est comprise entre 200 et 500 micromètres avant connexion de la matrice 6 au PCB de connexion 15. La hauteur h3 des connecteurs élémentaires 3, 4 après la connexion de la matrice de connexion 6 est comprise entre 50 et 150 µm. Aussi, le dépôt métallique est-il préférablement réalisé sur une hauteur comprise entre 50 et 150 µm

Dans un exemple non limitatif, la distance entre les connecteurs élémentaires 3, 4 et la paroi de protection 11 est comprise entre 100 et 500 µm, plus particulièrement entre 150 et 250 µm, par exemple 200 µm. Dans un exemple non limitatif, la largeur de la paroi de protection 11 est comprise entre 10 et 50 µm, offrant typiquement plusieurs dizaines de µm d'espacement avec les connecteurs élémentaires 3, 4. Généralement, les techniques d'impression 3D permettent un dépôt de gouttes métalliques d'une largeur de 10 µm.

Les dimensions ci-dessus, par exemple hauteur de 150 µm pour une largeur de 10 à 50 µm, montrent que la paroi de protection 11 s'étend de façon verticale par rapport au plan de la face de connexion 8.

Au moins une partie du dépôt métallique est réalisée sur la piste de masse 14 découverte, sur la borne de connexion localisée ou sur les sections longitudinales selon le cas, assurant la connexion électrique de la paroi 11 au plan de masse. L'illustration du bas de la Fig. 3B montre que l'ancrage de la paroi 11, et donc sa tenue mécanique, sont améliorées par la gravure du la couche isolante 18. Aussi, dans un mode de réalisation, la gravure a été effectuée sur l'ensemble des zones où le dépôt métallique doit être réalisé.

Ainsi, la paroi de protection 11 peut être directement déposée par un dépôt métallique dans la rainure entre les connecteurs élémentaires 3, 4 qui permet à la fois de réaliser la connexion électrique avec la piste de masse 14 et d'améliorer le maintien de la paroi de protection 11 dans une position perpendiculaire à la face de montage 7 du PCB porteur 5. La paroi de protection 11 est ainsi mieux fixée à la matrice de connexion 6.

La paroi de protection 11 permet d'absorber un signal électromagnétique des EMI émises par les connecteurs élémentaires 3, 4. Le signal ainsi absorbé par la paroi de protection 11 est ensuite conduit vers la piste de masse 14.

Dans une troisième étape optionnelle illustrée à la Fig. 3C, une couche d'isolation 9 électrique est déposée sur la paroi de protection 11 par les mêmes moyens de dépôt que la paroi de protection 11 décrits précédemment. La couche d'isolation 9 peut être l'un parmi une couche d'oxyde de silicium isolant, une résine époxy, un composite FR4, d'une résine polymères d'un silicone ou de polymères isolants.

Une ou plusieurs couches de 10 µm d'épaisseur peuvent être déposées par impression 3D.

La couche d'isolation 9 permet ainsi d'éviter un court-circuit entre les connecteurs élémentaires 3, 4 lors de connexion de la matrice de connexion 6 au PCB de connexion 15.

Comme illustré à la Fig. 2A, la paroi de protection 11 peut être déposée entre chaque connecteur élémentaire 3, 4, tels que les pads dans cet exemple non-limitatif. La paroi de protection 11 peut être déposée autour d'un connecteur élémentaire central 4A de la matrice de connexion 6, pour l'isoler de connecteurs élémentaires placés autour de lui.

Dans certains endroits de la matrice de connexion 6, le dépôt métallique peut être réalisé sur une largeur étendue par rapport à la hauteur, typiquement pour former une plaque 11a entre des connecteurs élémentaires 4A et 4B, au niveau par exemple d'une zone fortement émissive du PCB porteur 5.

Dans un mode de réalisation tel qu'illustré, la structure de protection 2 peut également comprendre une portion déposée sur le cadre périphérique 20 du PCB porteur 5, préférentiellement reliée à la ou les parois de protection 11 entre les connecteurs élémentaires 3, 4. Les émissions électro-magnétiques (EM) sur le bord du PCB porteur 5 sont réduites.

Grâce au dépôt métallique localisé, la structure de protection 2 présente une structure modulable pouvant prendre la forme nécessaire pour limiter les émissions EMI de certains ou tous les connecteurs élémentaires 3, 3A, 3B, 4, 4A, 4B.

Dans un exemple particulier, le dépôt métallique de la structure de protection 2 est effectué entre tous les connecteurs élémentaires 3, 4 de la matrice de connexion 6. Sur la Fig. 2A ce n'est pas le cas, par exemple entre les connecteurs élémentaires 3A et 3B. Le dépôt métallique formant paroi de protection 11 peut être réalisé sur des régions d'émission EMI les plus fortes seulement, déterminées par simulation numérique du boitier de circuit intégré 1, analysées via un logiciel adapté ou un détecteur spécialement conçu pour identifier les EMI présentes.

La fabrication additive de la structure de protection 2 par une impression 3D comme un exemple préféré, permet une grande liberté dans la forme et/ou les dimensions particulières de la structure de protection 2. Ainsi, seuls les connecteurs élémentaires 3, 4 les plus émetteurs peuvent être couverts par la structure de protection 2 qui permet d'accélérer le dépôt de la structure de protection et de limiter les dépenses du matériau métallique utilisé pour le dépôt de la structure de protection 2.

Dans un mode de réalisation dans lequel la soudure est utilisée comme un moyen de connexion de la matrice 6 au PCB de connexion 15, un flux de soudure est appliqué sur les connecteurs élémentaires 3, 4 et/ou sur la matrice de connexion 6. Le flux de soudure assure un meilleur procédé de soudure et de dessoudage en éliminant des films d'oxyde qui se forment à la surface des connecteurs élémentaires 3, 4 qui sont à souder avec le PCB de connexion 15.

Ainsi, lors du dépôt de la structure de protection 2, des ouvertures dans la paroi de protection 11 peuvent être prévues qui permettent la circulation du flux de soudure.

Par exemple, la hauteur h1 de la structure de protection 2 peut être réduite à des endroits prédéterminés entre les connecteurs élémentaires 3, 4 pour laisser passer le flux de soudure.

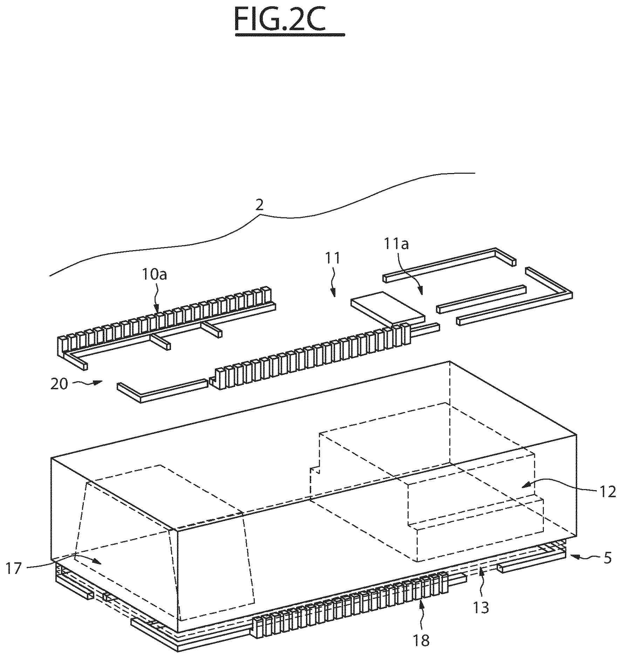

En variante, la structure de protection 2 peut être une forme géométrique ouverte (comme sur la Fig. 3C). La Fig. 2C illustre également une telle variante dans laquelle des parois de protection 11 sont formées entre certains connecteurs élémentaires seulement.

Lors de la soudure, la haute température peut être appliquée pour soudre les connecteurs élémentaires 3, 4 au PCB de connexion 15. Après soudure, les résidus du flux de soudure dans le procédé de soudure peuvent être évacués par une pression de l'air, par exemple, passée entre les ouvertures dans la structure de protection 2.

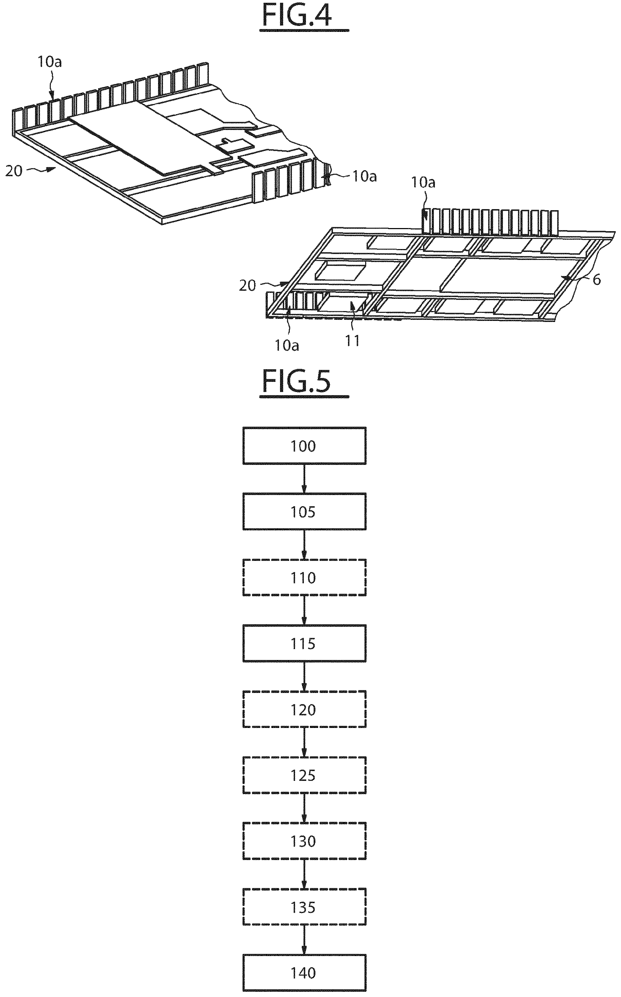

Faisant référence aux Fig. 2A-2C et à la Fig. 4, la structure de protection comprend au moins une première portion de protection 10a formée par dépôt métallique sur une tranche latérale 13 du PCB porteur 5. Pour des raisons de clarté, les tranches latérales 13 sont visibles uniquement sur la Fig. 2C mais elles sont également présentes dans les modes de réalisation des Fig. 2A-2B. Cette portion de protection 10a, dite portion latérale de protection, peut être formée lors de la même opération de dépôt métallique que celle de la paroi métallique 11 décrit précédemment.

En particulier, comme illustré, la portion latérale de protection 10a peut s'étendre sur la tranche latérale 13 depuis la portion 20 formant cadre périphérique du PCB porteur. De même plusieurs portions 10a sont formées sur plusieurs côtés du PCB porteur 5.

Une portion latérale de protection 10a peut comprendre plusieurs brins ou doigts reliés ensemble et ayant une forme d'un peigne s'étendant sur toute ou partie de la tranche latérale 13 du PCB porteur 5. L'utilisation d'une portion en forme de peigne permet de réduire le dépôt de matière métallique lors du dépôt de la portion de protection 10a et maintenir le boitier de circuit intégré 1 suffisamment léger. Le temps de dépôt est également réduit. En variante, la portion latérale de protection 10a présente une forme de plaque continue.

Les zones où déposer ces portions de protection en forme de peigne correspondent préférentiellement aux zones de forte émission EM, qui peuvent être déterminées par simulation numérique du boitier de circuit intégré 1.

La portion latérale de protection 10a peut s'étendre sur toute la hauteur du PCB porteur 5, ou sur une partie seulement (par exemple mi-hauteur ou 75% de la hauteur), selon par exemple que les zones / couches fortement émissives du PCB porteur 5 sont placées plus ou moins hautes dans le PCB porteur 5.

Dans un mode de réalisation, la portion latérale de protection 10a s'étend au-delà de l'épaisseur du PCB porteur 5, sur le côté du capot en résine 17, jusqu'à une hauteur des composants électriques 19 permettant de réduire également les EMI générées par ces composants électriques.

La portion latérale de protection 10a peut prendre diverses formes telles qu'un peigne, une plaque, une plaque avec des ouvertures ou une paroi inclinée en direction de la matrice de connexion 6 formant un angle non perpendiculaire au plan de la matrice.

Le tableau ci-dessus présente les tests comparatifs effectués sur le boitier de circuit intégré 1 avec la structure de protection 2 déposée avec un boitier de circuit intégré sans structure de protection.

Les « Zpos », « Ypos », « Yneg », « Xpos » et « Xneg » présentent les mesures de champs électromagnétiques dans le boitier de circuit intégré 1 selon les axes différents X, Y et Z. Trois réalisations sont étudiées, pour un même boitier 1 de circuit intégré.

Dans la première réalisation, des interconnexions par fil (connues sous l'appellation « wire bonding ») entre les composants électriques dans le boitier 1 ont été remplacées par le dépôt métallique (impression 3D) d'une bande métallique de connexion, pour réduire les émissions EMI des interconnexions.

Dans la deuxième réalisation, seules les parois de protection 11 entre les pads 3, 4 de la matrice de connexion 6 ainsi que la portion format cadre périphérique 20 ont été formées par dépôt métallique sur le boitier 1. Les interconnexions internes demeurent des interconnexions par fil.

Dans la troisième réalisation, les interconnexions par fil 20 ont été remplacées par des bandes métallique de connexion, les parois de protection 11 entre les pads 3, 4 de la matrice de connexion 6 ainsi que la portion format cadre périphérique 20 ont été formées par dépôt métallique, en outre des portions en forme de peigne ont été formées sur certaines tranches identifiées comme fortement émettrices.

Le tableau ci-dessous montre que la troisième réalisation de protection EMI fournit une diminution significative des champs électrique « E » et magnétiques « H » autour du boitier 1 selon tous les axes examinés.

| Réalisation | Zpos | | Ypos | | Yneg | | Xpos | | Xneg | |
|---|---|---|---|---|---|---|---|---|---|---|
| | E | H | E | H | E | H | E | H | E | H |
| 1^{ere} | -4 % | -20% | -1% | -3% | -2% | -36% | -2% | -34% | -1% | -3% |
| 2^{ème} | -5% | -6% | -42% | -20% | -28% | +16% | -26% | +1% | -46% | -20% |
| 3^{ème} | -13% | -30% | -46% | -26% | -51% | -23% | -27% | -36% | -52% | -26% |

Un logigramme d'un procède de fabrication du dispositif semi-conducteur est illustré à la Fig. 5.

A la première étape 100, le PCB porteur 5 est obtenu. Il peut déjà comprendre ou non la matrice de connexion 6, les composants électriques 19 et le capot de résine 17.

A la deuxième étape 105, la couche isolante 18 du PCB porteur 5 est gravée pour mettre à nu la piste de masse 14 entre des connecteurs élémentaires 3, 4, sous forme de borne de connexion localisée ou de sections longitudinales.

A l'étape optionnelle 110, les composants électroniques 19 et/ou la matrice de connexion 6 (par exemple les billes) sont montés sur face de montage 7 du PCB porteur 5, si nécessaire. Le capot en résine 17 peut être également déposé sur le PCB porteur 5 selon des techniques classiques.

A l'étape suivante 115, un dépôt métallique entre les connecteurs élémentaires 3, 4 est réalisé. Le dépôt métallique forme la paroi de protection 11 contre des interférences électromagnétiques entre les connecteurs élémentaires 3, 4. Si la piste de masse 14 a été mise à nu sur une zone où le dépôt métallique a lieu, la connexion électrique de la paroi 11 à la piste de masse 14 est réalisée à cette étape. Le dépôt métallique est réalisé par impression 3D dans un exemple préférentiel.

A l'étape optionnelle 120, la portion formant cadre périphérique 20 du PCB porteur 5 est déposée sur la face de montage 7. Le dépôt métallique est réalisé par impression 3D dans un exemple préférentiel, lors de la même opération d'impression 3D que l'étape 115.

A l'étape optionnelle 125, la portion latérale de protection 10a en forme de peigne est déposée sur les parties latérales du boitier 1. Le dépôt métallique est réalisé par impression 3D dans un exemple préférentiel, lors de la même opération d'impression 3D que l'étape 115 et/ou 120.

A l'étape optionnelle 130, la connexion électrique à la piste de masse 14 est réalisée par fil électrique entre la paroi 11 et la borne de connexion localisée mise à nu. Cette étape est réalisée dans le cas où la connexion électrique n'a pas été réalisée lors du dépôt métallique 115 de la paroi de protection 11.

A l'étape optionnelle 135, un dépôt de la couche d'isolation 9 sur les parois de protection 11 est réalisée. Le dépôt métallique est réalisé par impression 3D dans un exemple préférentiel.

A l'étape suivante 140, la connexion du boitier de circuit intégré 1 au PCB de connexion 15 est réalisée via leurs matrices de connexion 6 respectives. Cette connexion peut être réalisée par soudure.

### Numéros de référence

1 - boitier de circuit intégré
2 - structure de protection
3, 4, 3A, 4A, 4B - connecteurs élémentaires
5 - PCB porteur
6 - matrice de connexion
7 - face de montage de PCB porteur
8 - face de connexion de PCB porteur
9 - couche d'isolation
10a - portion latérale de protection
11 - paroi de protection
11a - plaque
13 - tranche latérale
14 - piste de masse
15 - PCB de connexion
16 - circuit intégré
17 - capot de boitier de circuit intégré
18 - couche isolante de PCB porteur
19 - composants électroniques
20 - cadre périphérique du PCB porteur
21 - matrice de connexion complémentaire
22 - face de connexion de PCB de connexion
23 - connecteurs élémentaires complémentaires

## Revendications

1. Procédé de fabrication d'un dispositif semi-conducteur comprenant les étapes de :
- obtenir un boitier de circuit intégré (1) présentant une matrice de connexion (6) pour une connexion à une carte de circuit imprimé (15) ;
- former une structure de protection (2) contre des interférences électromagnétiques entre les connecteurs élémentaires (3, 4) par impression 3D d'un dépôt métallique entre les connecteurs élémentaires (3, 4) de sorte à former une paroi de protection électromagnétique (11) entre les connecteurs élémentaires (3, 4).

2. Procédé de fabrication d'une structure protection (2) selon la revendication 1, comprend en outre une ou plusieurs opérations parmi :
une étape de dépôt d'une couche d'isolation (9) sur la paroi métallique (11),
une étape de dépôt métallique sur une tranche latérale (13) d'un circuit imprimé support (5) sur une face intérieure (8) duquel est disposée la matrice de connexion (6), de sorte à former une première portion de protection (10a) latérale,
une étape de dépôt métallique d'une deuxième portion de protection (20) formant cadre périphérique de la face inférieure (8) du circuit imprimé support (5).

3. Procédé de fabrication d'une structure protection (2) selon la revendication 2, dans lequel la dépôt de la couche d'isolation (9) est réalisé par impression 3D.

4. Procédé de fabrication d'une structure protection (2) selon la revendication 2, dans lequel l'au moins une première portion de protection (10a) présente la forme d'un peigne s'étendant sur une portion de la tranche latérale (13) du circuit imprimé support (5).

5. Procédé de fabrication d'une structure protection (2) selon la revendication 2 ou 4, dans lequel la structure de protection (2) comprend une deuxième portion de protection (20), réalisée par dépôt métallique, formant cadre périphérique de la face inférieure (8) du circuit imprimé support (5).

6. Procédé de fabrication d'une structure protection (2) selon l'une des revendications 1 à 5, dans lequel la paroi de protection (11) est électriquement connectée avec une piste de masse (14) du circuit intégré (16).

7. Procédé de fabrication d'une structure protection (2) selon la revendication 6, dans lequel au moins une partie de la paroi de protection (11) est déposée directement sur la piste de masse (14).

8. Procédé de fabrication d'une structure protection (2) selon l'une des revendications 1 à 7, dans lequel la structure de protection (2) comprend une couche d'isolation (9) couvrant la paroi de protection (11).

9. Procédé de fabrication d'une structure protection (2) selon l'une des revendications 1 à 8, dans lequel la matrice de connexion (6) est au moins l'une entre une matrice de broches (PGA), une matrice de billes (BGA), une matrice de pastilles (LGA) ou une matrice de colonnes (CGA).

10. Procédé de fabrication d'une structure protection (2) selon l'une des revendications 1 à 9, dans lequel la structure de protection (2) présente une hauteur (h1) selon l'axe perpendiculaire au plan de la matrice de connexion (6), substantiellement égale à une hauteur (h3) des connecteurs élémentaires (3, 4) après connexion de la matrice de connexion (6) à la carte de circuit imprimé (15).

11. Procédé de fabrication d'une structure protection (2) selon l'une des revendications 1 à 10, dans lequel la structure de protection (2) forme une grille de parois métalliques rectilignes, perpendiculaires entre elles, et disposées entre les connecteurs élémentaires (3, 4) organisés en quadrillage au sein de la matrice de connexion (6).
